# EUROPEAN PATENT APPLICATION

(11) **EP 4 818 805 A1**
(43) Date of publication of application: **07.10.2026**
(21) Application number: 25167330.7
(22) Date of filing: 31.03.2025
(51) Int. Cl.: G03F 7/00

(54) **A METHOD AND A SYSTEM FOR IMAGING A PATTERNING DEVICE**

(71) Applicant: ASML Netherlands B.V., 5500 AH Veldhoven (NL)
(72) Inventor: VAN LARE, Marie-Claire, 5500 AH Veldhoven (NL); BEEKMANS, Steven, Vincent, 5500 AH Veldhoven (NL)
(74) Representative: ASML Netherlands B.V.

(57) **Abstract**

A method of imaging a patterning device(MA) in a lithographic apparatus (LA) having an illumination system (IL) which is configured to condition a radiation beam (B) to have a desired spatial intensity distribution at a pupil plane of the illumination system (IL) and to focus the radiation beam (B) in an object plane where the patterning device (MA) is located. The method comprises: determining an illumination pupil defined in the pupil plane for illuminating the patterning device (102); measuring critical dimension values and/or reflectivity values of the patterning device (104); optimizing the illumination pupil based on the measured critical dimension values and/or the measured reflectivity values (106); and illuminating the patterning device using the optimized illumination pupil (108).

## Description

### FIELD

The present invention relates to a method and a system for imaging a patterning device. More particularly, it relates to a method and a system for optimizing an illumination pupil for illuminating the patterning device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

Patterns on conventional EUV reticles (i.e. patterning devices) may be optimized by using Source Mask Optimization (SMO) and optical proximity correction (OPC) software. Exposing/imaging such patterns onto wafers (substrates) in an EUV lithographic apparatus may result in suboptimal contrast of features (printed) on the substrate.

It is desirable to provide a method and system which addresses a problem associated with the prior art. It is desirable to improve contrast of features (printed) on the substrate in a lithographic apparatus.

### SUMMARY

According to a first aspect of the invention, there is provided a method of imaging a patterning device in a lithographic apparatus having an illumination system which is configured to condition a radiation beam to have a desired spatial intensity distribution at a pupil plane of the illumination system and to focus the radiation beam in an object plane where the patterning device is located, the method comprising: determining an illumination pupil defined in the pupil plane for illuminating the patterning device; measuring critical dimension values and/or reflectivity values of the patterning device; optimizing the illumination pupil based on the measured critical dimension values and/or the measured reflectivity values; and illuminating the patterning device using the optimized illumination pupil.

This may have an advantage of maximizing contrast (through slit) or at least improving contrast of features printed on a substrate (wafer), at least compared to previous systems with conventional standard optimization of illumination pupil.

The critical dimension values relate to the dimension of features on a substrate. The critical dimension values may be referred to as critical dimension. The reflectivity values may be referred to as reflectivity.

The method may comprise measuring the critical dimension values and/or the reflectivity values over at least part or all of the patterning device.

Determining the illumination pupil may comprise, before measurement of the critical dimension values and/or reflectivity values of the patterning device, optimizing the illumination pupil in a standard conventional manner, e.g. using source mask optimization, optimizing mask, e.g. using optical proximity correction, and manufacturing the patterning device.

Optimizing the illumination pupil (i.e. using the measurements of the critical dimension values and/or reflectivity values of the patterning device), which may be considered to be re-optimizing, may comprise starting from the current illumination pupil (i.e. the standard optimized illumination pupil) and tweaking (using the measurements) the standard optimized illumination pupil to obtain the (re-)optimized illumination pupil.

Optimizing the illumination pupil may comprise optimizing the illumination pupil for a plurality of positions in a slit between the illumination system and the patterning device.

The slit may be a gap through which the radiation beam passes from the illumination system to the patterning device. There may be less than 13 positions, 13 positions, or more than 13 positions in the slit that are used in the optimization.

Optimizing the illumination pupil may comprise optimizing the illumination pupil using source-mask optimization.

The source mask optimization may comprise using source-mask optimization software.

The source mask optimization may be used to re-optimize and compensate for sub-optimality in contrast due to critical dimension variations on the patterning device.

Source mask optimization may comprise making a theoretical pupil, rendering, and then making an actual pupil.

Optimizing the illumination pupil may comprise standard illumination pupil optimization with measured critical dimension values (e.g. adjusted critical dimension values) and/or the measured reflectivity values as inputs. Adjusted critical dimension values may be measured critical dimension values on the patterning device that are different from the expected/target critical dimension values.

Optimizing the illumination pupil may comprise compensating for critical dimension value deviations by modifying the illumination pupil using the measured critical dimension values.

Modifying the illumination pupil may comprise modifying shape of the illumination pupil.

Optimizing the illumination pupil may provide improved contrast of features on the substrate. This may be since consistent critical dimension on the patterning device may provide the best contrast.

The method may comprise determining the measured critical dimension values (i.e. absolute critical dimension values) and using the absolute critical values in the optimization.

The pupil-fill ratio (i.e. amount of the pupil plane that is filled with light) may be kept constant, e.g. at 20% or 15%. This may allow for a 100% illumination system efficiency.

Modifying the illumination pupil may comprise modifying the illumination pupil in slit direction and/or scanning direction.

The slit direction may be the longitudinal direction of the slit. The scanning direction may be orthogonal to the slit direction.

Modifying in the scanning direction may lead to throughput loss (e.g. due to the microswitches of the illumination system). Modifying in the scanning direction may be carried out if there are larger critical dimension variations.

Modifying the illumination pupil may comprise modifying the illumination pupil by lowering the pupil fill ratio.

The pupil fill ratio may be lowered below 20% or below 15%. Lowering the pupil fill ratio may provide a narrower angular distribution which may result in improved contrast. This may be for critical spots (e.g. where contrast is considered to be below a predetermined level).

Optimizing the illumination pupil may comprise compensating for critical dimension value deviations by modifying intensity of a pupil spot in the pupil plane of the illumination system.

This may improve critical dimension value deviations towards target critical dimension values.

The intensity of the pupil spot may be tuned using the illumination system during the optimization to better match the measured critical dimension values (i.e. reduce deviation between critical dimension values on substrate at a certain position in the field to target critical dimension values).

Modifying intensity of the pupil spot may comprise increasing intensity of the pupil spot in the pupil plane of the illumination system for areas of the patterning device with critical dimension value deviations with respect to a predetermined value.

This may be to compensate critical dimension variations on the substrate which are due to reflectivity variations on the patterning device.

The predetermined value may be an average critical dimension value or target critical dimension value for the patterning device.

The method may further comprise compensating for reflectivity value deviations by modifying dose of the radiation beam.

It will be appreciated that, in an aspect of the invention, modifying dose of a radiation beam using measurements of reflectivity values of a patterning device may be carried out without optimizing an illumination pupil using measurements of the critical dimension values and/or reflectivity values of the patterning device.

Modifying dose of the radiation beam may improve critical dimension value deviations towards target critical dimension values.

Modifying dose of the radiation beam may be by using an image optimizer dose application.

The method may comprise determining whether and/or how much the reflectivity values deviate from target reflectivity values.

Increasing dose of the radiation beam may comprise increasing dose of the radiation beam for areas of the patterning device with reflectivity values below a predetermined value.

The predetermined value may be an average reflectivity or target reflectivity for the patterning device.

Measuring the critical dimension values of the patterning device may comprise measuring the critical dimension values of the patterning device using at least one of: a detector, a scanning electron microscope, a mask inspection tool, an aerial image metrology system and/or measuring the reflectivity values of the patterning device may comprise measuring the reflectivity values of the patterning device using at least one of: a detector, reflectivity metrology, a sub E0 measurement system, a mask inspection tool, and/or an aerial image metrology system.

The (EUV) mask inspection tool (e.g. aerial image metrology system) may measure reflectivity or an image as formed by the mask (i.e. an aerial image of the mask). The image may be formed on a camera in the same way as it may be formed on a substrate.

The scanning electron microscope (SEM) may measure critical dimension on the patterning device.

The method may comprise using scanning electron microscopy.

The sub E0 measurement may be measured on the substrate. The sub E0 measurement may be a measure of threshold energy of the resist on the substrate that has been exposed without a pattern, i.e. measure resist thickness.

The method may further comprise using optimized illumination pupil settings based on measurements of the patterning device for at least one other patterning device.

The at least one other patterning device may be from same batch process as the patterning device. The at least one other patterning device may be a plurality of patterning devices (e.g. each from the same batch process). This means that the optimized illumination settings may be used for patterning device(s) without additional metrology.

The lithographic apparatus may comprise a projection system configured to project a patterned radiation beam onto a substrate, the method may further comprise measuring critical dimension values and/or values related to contrast of the substrate, and at least one of: further optimizing the illumination pupil based on the measured critical dimension values and/or the measured values related to contrast of the substrate; and/or determining the improvement of optimizing the illumination pupil using the measurements of the patterning device by comparing a substrate exposed using the illumination pupil and another substrate exposed using the optimized illumination pupil.

The method may further comprise measuring using critical dimension values and/or values related to contrast of the substrate using a substrate detector.

The critical dimension values of the substrate may be critical dimension variation. The values related to contrast of the substrate may be local critical dimension uniformity.

Further optimizing the illumination pupil may comprise modifying the illumination pupil, modifying the intensity of the pupil spot and/or modifying the dose of the radiation beam. The dose may be increased or decreased as required.

Determining the improvement may comprise measuring using a substrate detector (e.g. based on SEM metrology) to measure the substrate. This may improve the identification of critical parts in the field.

According to a second aspect of the invention, there is provided a system configured to optimize an illumination pupil for illuminating a patterning device by a radiation beam based on measured critical dimension values and/or measured reflectivity values of the patterning device measured by a detector, the radiation beam conditioned by an illumination system to have a desired spatial intensity distribution at a pupil plane of the illumination system and focused to an object plane where the patterning device is located.

The system may be configured to further optimize the illumination pupil based on measured critical dimension values and/or measured values related to contrast of a substrate measured by a substrate detector, the substrate having a patterned radiation beam projected thereon by a projection system.

According to a third aspect of the present invention, there is provided a lithographic apparatus comprising the system as described above, an illumination system, and a projection system, wherein the lithographic apparatus is configured to illuminate the patterning device using the optimized illumination pupil.

The lithographic apparatus may be an EUV lithographic apparatus.

According to a fourth aspect of the present invention, there is provided a lithographic apparatus comprising an illumination system and a projection system, wherein the lithographic apparatus is configured to illuminate the patterning device using an optimized illumination pupil based on measured critical dimension values and/or measured reflectivity values of a patterning device measured by a detector.

According to a fifth aspect of the present invention, there is provided a computer program comprising computer readable instructions configured to cause a processor to carry out a method as described above.

According to a sixth aspect of the present invention, there is provided a computer readable medium carrying a computer program as described above.

According to a seventh aspect of the present invention, there is provided a computer apparatus comprising: a memory storing processor readable instructions; and a processor arranged to read and execute instructions stored in said memory; wherein said processor readable instructions comprise instructions arranged to control the computer to carry out a method as described above.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source and detectors for measurement on the patterning device and the substrate;
- Figure 2 depicts a method of imaging a patterning device in a lithographic apparatus according to an embodiment of the invention;
- Figure 3 depicts a method of imaging another patterning device according to an embodiment of the invention;
- Figure 4 depicts a method of using measurements from a substrate in a lithographic apparatus LA according to an embodiment of the invention.

### DETAILED DESCRIPTION

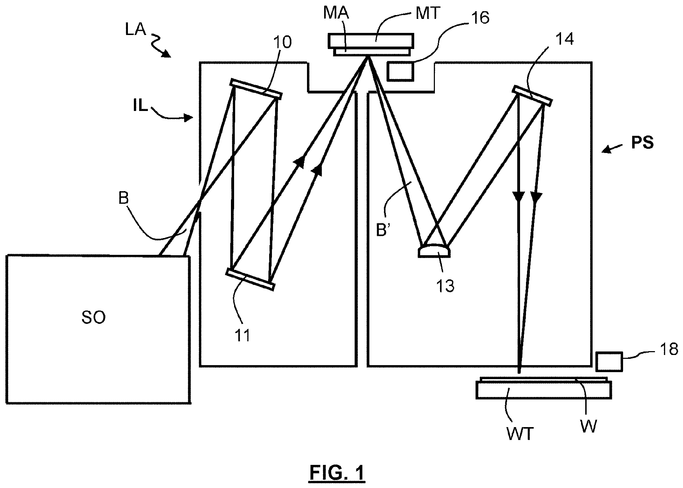

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

A detector 16 (i.e. patterning device detector) and a substrate detector 18, which may be referred to more generally as metrology apparatuses, are provided for making measurements on the patterning device MA and the substrate W respectively. It will be appreciated that the detector 16 and the substrate detector 18 may be considered to not form part of the lithographic apparatus LA or lithographic system.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

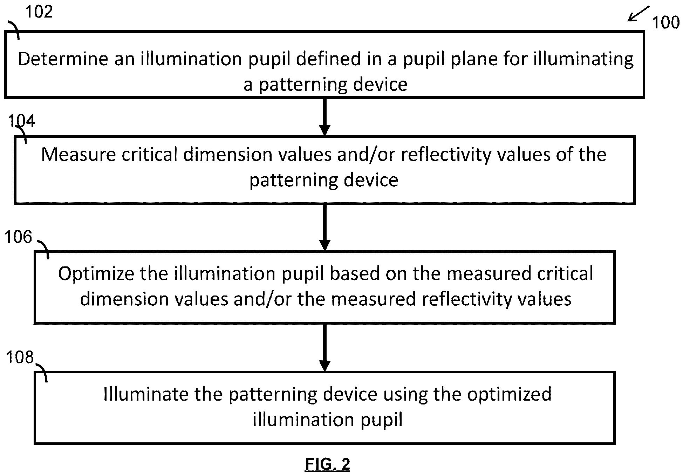

Figure 2 illustrates a method 100 of imaging a patterning device MA in the lithographic apparatus LA. The lithographic apparatus LA has the illumination system IL which is configured to condition the radiation beam B to have a desired spatial intensity distribution at a pupil plane of the illumination system IL and to focus the radiation beam B in an object plane where the patterning device MA is located.

A first step 102 is determining an illumination pupil defined in the pupil plane for illuminating the patterning device. The illumination pupil is input to the lithographic apparatus LA, based on an optimization algorithm. It may be measured to see if it functions well.

This may involve standard optimization of the illumination pupil (i.e. optimizing the illumination pupil in a conventional manner before the patterning device is manufactured), e.g. using source mask optimization. Then, optimizing the patterning device MA, e.g. using optical proximity correction, and then manufacturing the patterning device MA. Once the patterning device MA is manufactured then measurement of the patterning device MA may be made, e.g. outside of the lithographic apparatus LA. Measurements may also be made inside of the lithographic apparatus LA. For example, measurements of the substrate W that has been exposed using a pattern from the patterning device MA may also be made. For this, the patterning device may be placed on the support structure MT in the lithographic apparatus LA, illuminated by the radiation beam B and then measurements of the substrate W may be made.

A second step 104 is measuring critical dimension values (CDV) and/or reflectivity values (RV) of the patterning device MA. These measurements may be used to characterize a patterning device fingerprint over the imaging field of the patterning device MA.

The CDV relate to the dimension of features to be printed on the substrate W. CDV of the substrate W may be referred to as critical dimension.

The CDV and/or RV are measured by the detector 16. It will be appreciated that they may be measured by one or more different detectors as applicable. The CDV be measured by a scanning electron microscope (SEM) and the method may comprise using scanning electron microscopy. The CDV and/or the RV may be measured by a mask inspection tool (e.g. an aerial image metrology system) on a mask (the patterning device MA may be referred to as a mask). The (EUV) mask inspection tool (e.g. aerial image metrology system) may measure reflectivity or an image as formed by the mask (i.e. an aerial image of the mask). The image may be formed on a camera in the same way as it may be formed on the substrate W.

The RV may be measured using reflectivity metrology on the patterning device MA. The reflectivity values may be measured using a sub E0 measurement system on the substrate W. The sub E0 measurement is measured on the substrate W. Thus, in this case, RV of the patterning device MA are measured through measurements made on the substrate W (e.g. using the substrate detector 18). Thus, although the sub E0 measurements are actually made on the substrate W, it will be appreciated that this may be covered under, or defined as, measurements of the RV of the patterning device MA since these RV measurements are related to the patterning device MA rather than the substrate W. The sub E0 measurement may be a measure of threshold energy of the resist on the substrate W that has been exposed without a pattern, i.e. it may measure resist thickness - this may provide a measurement of reflectivity values on the patterning device MA.

The measurements of CDV and/or RV may be spread over all of the patterning device MA but this does not necessarily mean the entire patterning device MA must be measured. For example, measurements may be made to the extent that the variance of the feature critical dimension over the patterning device field is indicated. Thus, measurements may be made over at least part or all of the patterning device MA.

The method may involve producing a measured CDV variation map and/or a measured RV map.

A third step 106 is optimizing the illumination pupil based on the measured critical dimension values and/or the measured reflectivity values. This may be referred to as re-optimizing as standard conventional optimization of the illumination pupil may have already occurred. For re-optimizing the illumination pupil, it may be helpful to start from the current illumination pupil (i.e. the standard optimized illumination pupil) and tweak (using the measurements) to obtain the re-optimized illumination pupil.

In the lithographic apparatus LA, there is a slit (not shown) which is a gap through which the radiation beam B passes from the illumination system IL to the patterning device MA. The illumination pupil is optimized for a plurality of positions in the slit. For example, there may be 13 positions in the slits that are used for the optimization. However, it will be appreciated that this is just an example and there may be more or less than 13 positions used.

Optimizing the illumination pupil using the measured critical dimension values (CDV) and/or the measured reflectivity values (RV) may include using source mask optimization (SMO), or more particularly source mask optimization software. This may be standard illumination pupil optimization with measured CDV (e.g. adjusted critical dimension values) and/or the measured reflectivity values as inputs. Adjusted CDV may be measured CDV on the patterning device MA that are different from expected/target CDV.

Source mask optimization may comprise making a theoretical pupil, rendering, and then making an actual pupil. The source mask optimization may be used to re-optimize and compensate for sub-optimality in contrast (of features on the substrate W) due to critical dimension variations on the patterning device MA.

Critical dimension values (CDV) may deviate from expected or target CDV and they may be considered to be critical dimension values deviations (CDVD). In order to compensate for CDVD, the illumination pupil is modified using the measured CDV. Modifying the illumination pupil may comprise modifying shape of the illumination pupil. The method may comprise determining the measured CDV (i.e. absolute CDV) and using the absolute CDV in the optimization. The pupil-fill ratio (i.e. amount of the pupil plane that is filled with light) may be kept constant, e.g. at 20% or 15%. This may allow for a 100% illumination system IL efficiency.

Optimizing the illumination pupil in this way may have an advantage that this may provide improved contrast of features on the substrate W. This may be since consistent critical dimension on the patterning device MA may provide the best contrast.

The illumination pupil may be modified in the slit direction and/or the scanning direction. The slit direction may be the longitudinal direction of the slit. The scanning direction is orthogonal to the slit direction. However, modifying in the scanning direction may lead to throughput loss in the lithographic apparatus LA (e.g. due to the microswitches of the illumination system). Thus, modifying in the scanning direction may be carried out only when the benefits outweigh the disadvantages of potential throughput loss. For example, modifying in the scanning direction may be carried out if there are larger critical dimension variations.

The illumination pupil may be modified by lowering the pupil fill ratio. For example, the pupil fill ratio may be lowered to below 20% or below 15%. Lowering the pupil fill ratio may provide a narrower angular distribution which may result in improved contrast. This may be for critical spots (e.g. where contrast is considered to be below a predetermined level). However, this may come at the expense of throughtput of the lithographic apparatus LA. This may be because reducing the pupil fill ratio may reduce the light that is incident on the patterning device MA. Thus, the exposure time may need to be increased which may result in it taking longer to image the substrate W and thus a reduction in throughput in the lithographic apparatus LA.

Another way to compensate for critical dimension values deviation (CDVD) is to modify intensity of a pupil spot in the pupil plane of the illumination system IL. The intensity of the pupil spot may be tuned using the illumination system IL during the optimization to better match the measured CDV (i.e. reduce deviation between CDV on the substrate W at a certain position in the field to be closer, close to or the same as expected or target CDV). This has an advantage that this may improve CDVD towards target CDV.

Modifying the intensity of the pupil spot may include increasing intensity of the pupil spot in the pupil plane of the illumination system IL for areas of the patterning device MA with CDVD with respect to a predetermined value. The predetermined value may be an average CDV or target CDV for the patterning device MA. This means that areas of the patterning device that have CDVD with respect to e.g. an average CDV or target CDV may have corresponding increase in intensity of the pupil spot. It will be appreciated that both CDVD that are less than or more than the average or target CDV can be corrected. This may have an advantage of compensating for critical dimension variations on the substrate W, which are due to reflectivity variations on the patterning device MA.

Advantageously, imperfections in the patterning device MA may be measured and then corrected for. Optimizing the illumination pupil may have an advantage of maximizing contrast (through the slit) or at least improving contrast of features printed on the substrate (wafer) W. Previous conventional systems may have had sub-optimal performance through slit which may have led to contrast degradation.

A fourth step 108 is illuminating the patterning device MA using the optimized illumination pupil.

The illumination pupil is adjusted after mask optimization and tape out. Thus, the illumination pupil is adjusted post tape-out (i.e. after the patterning device MA has been manufactured).

Reflectivity values (RV) may deviate from expected or target RV and they may be considered to be reflectivity value deviations. There may be a further step between steps 106 and 108 of compensating for reflectivity value deviations by modifying dose of the radiation beam B. Modifying the dose of the radiation beam B may improve critical dimension value deviations (CDVD) towards expected or target critical dimension values (CDV).

Areas of the patterning device MA with relatively poor reflectivity (e.g. below average reflectivity or target reflectivity for the patterning device MA) may reflect less light back than other areas of the patterning device MA. Thus, the dose of the radiation beam B may be increased for these areas, e.g. areas of the patterning device MA with reflectivity values (RV) below a predetermined value. The predetermined value may be an average reflectivity or target reflectivity for the patterning device MA.

Modifying dose of the radiation beam B may be by using an image optimizer dose application. The method may comprise determining whether and/or how much the RV deviate from target RV. Here the relative comparison is important. The relative comparison and/or the RV may be fed into the image optimizer dose application and then the dose for particular areas is determined and thus the radiation beam B may be provided with the dose modified accordingly.

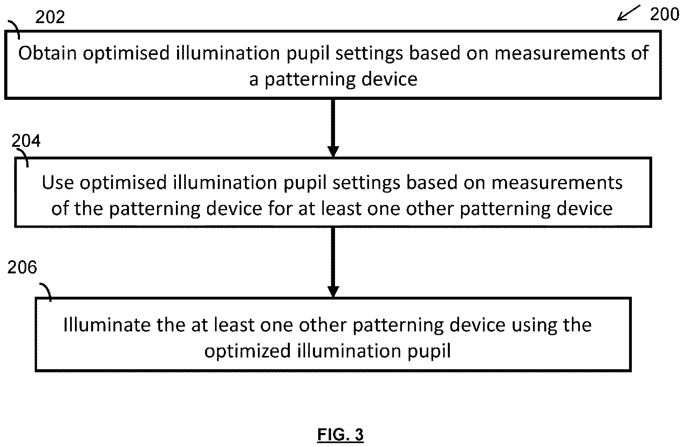

Figure 3 illustrates a method 200 of imaging another patterning device MA2 in the lithographic apparatus LA.

A first step 202 is obtaining optimized illumination pupil settings based on measurements of a patterning device MA. These optimized pupil settings may be those used to optimize the illumination pupil as in step 106.

A second step 204 is using optimized illumination pupil settings based on measurements of the patterning device MA for at least one other patterning device MA2.

The at least one other patterning device MA2 may be from the same batch process as the patterning device MA. There may be a plurality of other patterning devices MA2 (e.g. each from the same batch process) and the optimized illumination pupil settings may be used for each of these other patterning devices MA2.

This means that the optimized illumination settings may be used for other patterning devices MA2 without additional metrology. That is, measurements of CDV and/or RV may only need to be made once (on patterning device MA) and these measurement made be used for the other patterning devices MA2. Since the patterning device MA and the other patterning devices MA2 are manufactured in the same way, they require the same illumination and dose correction.

A third step 206 is illuminating the other patterning device MA2 using the optimized illumination pupil. The optimized illumination pupil is used to illuminate the other patterning devices MA2. Thus, the previously made optimization may be used pre-tape out (i.e. before the other patterning device MA2 is manufactured).

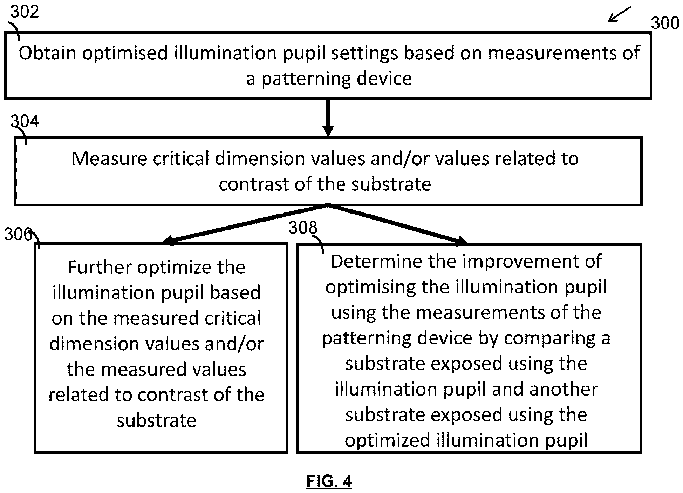

Figure 4 illustrates a method 300 of using measurements from the substrate W in a lithographic apparatus LA.

A first step 302 is obtaining optimized illumination pupil settings based on measurements of a patterning device MA. These optimized pupil settings may be those used to optimize the illumination pupil as in step 106.

A second step 304 is measuring critical dimension values and/or values related to contrast of the substrate W. More particularly, contrast may be contrast of features on the substrate W.

The critical dimension values of the substrate W may be critical dimension variation on the substrate W. The values related to contrast of the substrate W may be local critical dimension uniformity values.

The critical dimension values and/or values related to contrast of the substrate W are measured by the substrate detector 18. The substrate detector 18 may be based on SEM metrology, e.g. the detector 18 may be a SEM. It will be appreciated that they may be measured by one or more different detectors as applicable.

A third step 306 is further optimizing the illumination pupil based on the measured critical dimension values and/or the measured values related to contrast of the substrate W.

Similar to as mentioned above re using measurements from the patterning device MA, optimizing the illumination pupil may include modifying the illumination pupil, and/or modifying the intensity of the pupil spot. Furthermore, the dose of the radiation beam B may be modified. The dose may be increased, e.g. to print features larger if contact holes print too small in field. The dose may also be reduced, if required.

Correcting using substrate W measurements may be less obvious than the correction using patterning device MA measurements (e.g. it may be less clear where the imperfections arise, e.g. since the radiation beam B has also passed through the projection system PS). It may help improve contrast but it won't be the same as optimizing using the patterning device MA measurements as it is difficult to translate back to patterning device MA.

A fourth step 308 is determining the improvement of optimizing the illumination pupil using the measurements of the patterning device MA by comparing a substrate exposed using the (pre optimized) illumination pupil and another substrate exposed using the optimized illumination pupil.

This may have an advantage of improving the identification of critical parts in the field.

Measurements to determine the improvement of using the optimized illumination pupil are made using the substrate detector 18. The substrate detector 18 may be based on SEM metrology, e.g. the detector 18 may be a SEM. It will be appreciated that they may be measured by one or more different detectors as applicable.

It will be understood that only one of the third step 306 and the fourth step 308 may be carried out or both steps may be carried out.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of imaging a patterning device in a lithographic apparatus having an illumination system which is configured to condition a radiation beam to have a desired spatial intensity distribution at a pupil plane of the illumination system and to focus the radiation beam in an object plane where the patterning device is located, the method comprising:
determining an illumination pupil defined in the pupil plane for illuminating the patterning device;
measuring critical dimension values and/or reflectivity values of the patterning device;
optimizing the illumination pupil based on the measured critical dimension values and/or the measured reflectivity values; and
illuminating the patterning device using the optimized illumination pupil.

2. The method of claim 1, wherein optimizing the illumination pupil comprises optimizing the illumination pupil for a plurality of positions in a slit between the illumination system and the patterning device.

3. The method of any preceding claim, wherein optimizing the illumination pupil comprises optimizing the illumination pupil using source-mask optimization.

4. The method of any preceding claim, wherein optimizing the illumination pupil comprises compensating for critical dimension value deviations by modifying the illumination pupil using the measured critical dimension values.

5. The method of claim 4, wherein modifying the illumination pupil comprises modifying the illumination pupil in slit direction and/or scanning direction.

6. The method of either of claims 4 or 5, wherein modifying the illumination pupil comprises modifying the illumination pupil by lowering the pupil fill ratio.

7. The method of any preceding claim, wherein optimizing the illumination pupil comprises compensating for critical dimension value deviations by modifying intensity of a pupil spot in the pupil plane of the illumination system.

8. The method of claim 7, wherein modifying intensity of the pupil spot comprises increasing intensity of the pupil spot in the pupil plane of the illumination system for areas of the patterning device with critical dimension value deviations with respect to a predetermined value.

9. The method of any preceding claim, further comprising compensating for reflectivity value deviations by modifying dose of the radiation beam.

10. The method of claim 9, wherein increasing dose of the radiation beam comprises increasing dose of the radiation beam for areas of the patterning device with reflectivity values below a predetermined value.

11. The method of any preceding claim, wherein measuring the critical dimension values of the patterning device comprises measuring the critical dimension values of the patterning device using at least one of: a detector, a scanning electron microscope, a mask inspection tool, an aerial image metrology system and/or measuring the reflectivity values of the patterning device comprises measuring the reflectivity values of the patterning device using at least one of: a detector, reflectivity metrology, a sub E0 measurement system, a mask inspection tool, and/or an aerial image metrology system.

12. The method of any preceding claim, further comprising using optimized illumination pupil settings based on measurements of the patterning device for at least one other patterning device.

13. The method of any preceding claim, wherein the lithographic apparatus comprises a projection system configured to project a patterned radiation beam onto a substrate, the method further comprising measuring critical dimension values and/or values related to contrast of the substrate, and at least one of:
further optimizing the illumination pupil based on the measured critical dimension values and/or the measured values related to contrast of the substrate; and/or
determining the improvement of optimizing the illumination pupil using the measurements of the patterning device by comparing a substrate exposed using the illumination pupil and another substrate exposed using the optimized illumination pupil.

14. A system configured to optimize an illumination pupil for illuminating a patterning device by a radiation beam based on measured critical dimension values and/or measured reflectivity values of the patterning device measured by a detector, the radiation beam conditioned by an illumination system to have a desired spatial intensity distribution at a pupil plane of the illumination system and focused to an object plane where the patterning device is located.

15. The system of claim 14, wherein the system is configured to further optimize the illumination pupil based on measured critical dimension values and/or measured values related to contrast of a substrate measured by a substrate detector, the substrate having a patterned radiation beam projected thereon by a projection system.

16. A lithographic apparatus comprising the system of either of claims 14 or 15, an illumination system, and a projection system, wherein the lithographic apparatus is configured to illuminate the patterning device using the optimized illumination pupil.

17. A computer program comprising computer readable instructions configured to cause a processor to carry out a method according to any of claims 1-13.

18. A computer readable medium carrying a computer program according to claim 17.

19. A computer apparatus comprising:
a memory storing processor readable instructions; and
a processor arranged to read and execute instructions stored in said memory;
wherein said processor readable instructions comprise instructions arranged to control the computer to carry out a method according to any of claims 1-13.
